Europäisches Patentamt

European Patent Office

Office européen des brevets

(19)

(11) EP 1 427 018 A1

(12) **EUROPEAN PATENT APPLICATION**
published in accordance with Art. 158(3) EPC

(43) Date of publication:
**09.06.2004 Bulletin 2004/24**

(51) Int Cl.⁷: **H01L 27/12**

(21) Application number: **03765286.4**

(86) International application number:
**PCT/JP2003/008895**

(22) Date of filing: **14.07.2003**

(87) International publication number:
**WO 2004/010504 (29.01.2004 Gazette 2004/05)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **24.07.2002 JP 2002215000**

(71) Applicant: **Disco Corporation**
**Ota-ku, Tokyo 144-8650 (JP)**

(72) Inventors:
• **TAKAHASHI, Toshiaki, c/o Disco Corporation**
 **Ota-ku, Tokyo 144-8650 (JP)**
• **ARAI, Kazuhisa, c/o Disco Corporation**
 **Ota-ku, Tokyo 144-8650 (JP)**

(74) Representative: **Müller-Boré & Partner**
**Patentanwälte**
**Grafinger Strasse 2**
**81671 München (DE)**

(54) **METHOD FOR PROCESSING SOI SUBSTRATE**

(57)    A method for processing an SOI substrate composed of a backing layer comprising a semiconductor substrate, an insulating layer laminated on the upper surface of the backing layer, a thin semiconductor film layer laminated on the upper surface of the insulating layer, and circuits formed on the face of the thin semiconductor film layer, the method including: a grinding step of grinding the backing layer so as to remain with a predetermined thickness; and an etching step of removing the backing layer, which has been formed to the predetermined thickness by the grinding step, by chemical etching to expose the insulating layer.

Fig. 2

## Description

Technical Field

This invention relates to a method for processing an SOI substrate which has an insulating layer formed on the upper surface of a backing layer comprising a semiconductor substrate, and has circuits formed on the face of a thin semiconductor film layer formed on the upper surface of the insulating layer.

Background Art

In recent years, an SOI substrate, which has an insulating layer formed on the upper surface of a backing layer comprising a semiconductor substrate and has circuits formed on the face of a thin semiconductor film layer formed on the upper surface of the insulating layer, has been put to practical use in order to obtain semiconductor chips with an increased signal processing speed. This SOI substrate is constructed by the wafer laminating method in which semiconductor substrates of silicon or the like having an insulating layer, such as an oxide film, formed on the surface thereof are bonded together in face-to-face relationship; or the SIMOX method in which oxygen atoms are ion-implanted into a semiconductor substrate of silicon or the like, followed by performing heat treatment, to form an insulating layer, such as an oxide film, within the semiconductor substrate. Then, the semiconductor substrate on one side is thinned by polishing or the like to form a thin semiconductor film layer, and circuits are formed on the face of the thin semiconductor film layer. The so formed SOI substrate is subjected to dicing of respective regions, where the circuits are formed, whereby individual semiconductor chips are produced.

The semiconductor chip constructed in the above-described manner, desirably, has as small a thickness as possible, in order that its heat sink properties and electrical properties are satisfactory, or in order that a plurality of the semiconductor chips are stacked to constitute a semiconductor device having a multilayer structure. For this purpose, before the SOI substrate is divided into individual semiconductor chips, the backing layer comprising the semiconductor substrate is ground to have a predetermined thickness.

However, if the backing layer comprising the semiconductor substrate constituting the SOI substrate is mechanically ground with a grinding wheel, the insulating layer such as an oxide film may be damaged. To prevent this possibility, grinding is stopped about 70 μm before the insulating layer. This poses the problem that sufficiently thin semiconductor chips cannot be produced. Moreover, stress remains in the ground backing layer, causing the problem that the resulting semiconductor chips warp, or their transverse rupture strength declines.

Disclosure of the Invention

The present invention has been accomplished in the light of above-mentioned facts. A principal technical challenge for the invention is to provide a method for processing an SOI substrate, which can process the substrate thinly, without causing grinding-associated stress not to remain.

According to the present invention, aimed at solving the above principal technical challenge, there is provided a method for processing an SOI substrate composed of a backing layer comprising a semiconductor substrate, an insulating layer laminated on the upper surface of the backing layer, a thin semiconductor film layer laminated on the upper surface of the insulating layer, and circuits formed on the face of the thin semiconductor film layer,

the method being characterized by including an etching step of removing the backing layer by chemical etching to expose the insulating layer.

According to the present invention, there is also provided a method for processing an SOI substrate composed of a backing layer comprising a semiconductor substrate, an insulating layer laminated on the upper surface of the backing layer, a thin semiconductor film layer laminated on the upper surface of the insulating layer, and circuits formed on the face of the thin semiconductor film layer,

the method being characterized by including:

a grinding step of grinding the backing layer so as to remain with a predetermined thickness; and an etching step of removing the backing layer, which has been formed to the predetermined thickness by the grinding step, by chemical etching to expose the insulating layer.

The predetermined thickness of the backing layer remaining in the above grinding step is set at 100 to 10 μm. The backing layer is formed from silicon (Si), and the insulating layer is formed from silicon oxide ($SiO_2$). The chemical etching in the above etching step is performed using an etching solution containing fluorine and nitric acid.

Brief Description of the Drawings

FIG. 1 is a perspective view of an SOI substrate.
FIG. 2 is a sectional enlarged view of the SOI substrate shown in FIG. 1.
FIG. 3 is a schematic view showing an example of an etching device used for practicing the present invention.
FIG. 4 is an essential perspective view showing an example of a grinding device used for practicing the present invention.

Best Mode for Carrying Out the Invention

Preferred embodiments of a method for processing an SOI substrate according to the present invention will be described in greater detail by reference to the accompanying drawings.

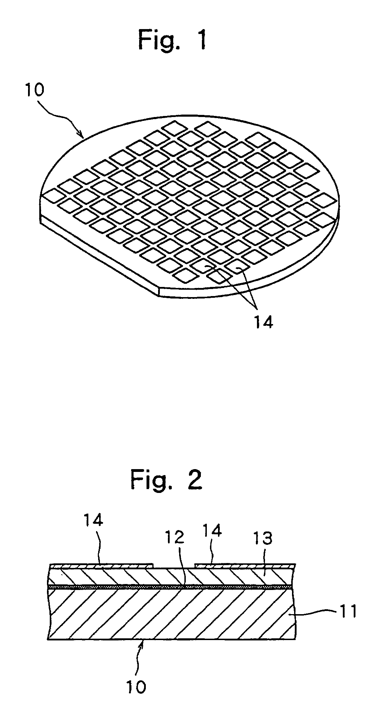

FIG. 1 shows a perspective view of an SOI substrate, and FIG. 2 shows a section, in an enlarged manner, of the SOI substrate illustrated in FIG. 1.

The illustrated SOI substrate 10 is composed of a backing layer 11 comprising a silicon (Si) substrate, an insulating layer 12 laminated on the upper surface of the backing layer 11 and comprising silicon oxide ($SiO_2$), a thin semiconductor film layer 13 laminated on the upper surface of the insulating layer 12 and comprising a silicon (Si) substrate, and circuits 14 formed on the face of the thin semiconductor film layer 13. The SOI substrate 10 is constructed, for example, by the aforementioned wafer laminating method or SIMOX method. The thicknesses of the respective layers constituting the SOI substrate 10 are about 400 μm for the backing layer 11, about 0.1 to 0.5 μm for the insulating layer 12, and about 2 to 3 μm for the thin semiconductor film layer 13 and the circuit 14.

In the first embodiment according to the present invention, the backing layer 11 comprising the silicon (Si) substrate constituting the SOI substrate 10 is removed by chemical etching.

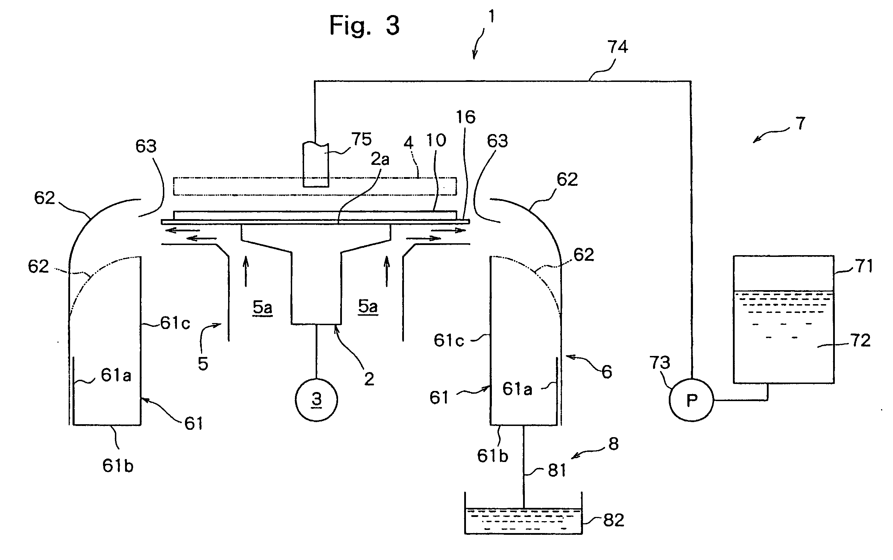

An etching device is now described with reference to FIG. 3. An etching device 1 shown in FIG. 3 is furnished with a spinner table 2 for holding the SOI substrate 10 to be etched. The spinner table 2 is disposed rotatably, and has at an upper end thereof a substantially horizontal, flat circular support surface 2a. An electric motor 3, as a drive source, is connected to the spinner table 2 via a suitable power transmission mechanism (not shown). When the electric motor 3 is driven, the spinner table 2 is rotated at a required rotational speed.

Transport means 4, illustrated in a simplified manner in FIG. 3, is disposed in association with the spinner table 2. The transport means 4 may be of a well known form by which the SOI substrate 10 can be vacuum attracted to the front end of a moving arm and transported through a required path. The transport means 4 brings in single SOI substrate 10 onto the spinner table 2, and brings the SOI substrate 10 from above the spinner table 2 out to a required site after an etching step and a rinsing/drying step which will be described later. The SOI substrate 10 to be brought in onto the spinner table 2 is brought in onto the spinner table 2, with the SOI substrate 10 being turned upside down, namely, with its backing layer 11 being directed upwards. A protective member 16, which can be formed from a suitable plastic film, is stuck to the face of the SOI substrate 10, namely, the face of the thin semiconductor film layer 13 where the circuits 14 are formed (see FIGS. 1 and 2). Thus, the protective member 16 is placed on the spinner table 2, while the backing layer 11 of the SOI substrate 10 is located on an upper side. The outer diameter of the SOI substrate 10 placed on the spinner table 2 is somewhat larger than the outer diameter of the circular support surface 2a of the spinner table 2.

In the illustrated etching device 1, air blow means 5 is annexed to the spinner table 2. The air blow means 5 has a channel 5a extending from a lower portion of the spinner table 2 to its peripheral edge and further extending along the lower surface of the SOI substrate 10 held on the spinner table 2. Air supplied from a compressed air source (not shown) flows from the peripheral edge of the spinner table 2 along the lower surface of the SOI substrate 10, thus preventing an etching solution applied to the upper surface of the SOI substrate 10 from flowing onto the lower surface of the SOI substrate 10. The spinner table 2 is also provided with etching solution recovery means 6 for recovering the etching solution applied to the upper surface of the SOI substrate 10 on the spinner table 2. The etching solution recovery means 6 is composed of a stationary member 61 and a movable member 62 which collaboratively form a recovery tank. The stationary member 61 has a cylindrical outer wall 61a, an annular bottom wall 61b, and a cylindrical inner wall 61c. The movable member 62 has a cylindrical lower portion, and an upper portion in an arcuate sectional shape. During the time the etching solution is applied to the upper surface of the SOI substrate 10 on the spinner table 2, the movable member 62 is located at an ascent position indicated by solid lines in the drawing. During this period, the etching solution flowing radially over the upper surface of the SOI substrate 10 is thrown into the etching solution recovery means 6 through an annular inlet 63 defined between the upper end of the inner wall 61c of the stationary member 61 and the upper end of the movable member 62. When rinsing the SOI substrate 10 by applying thereto a cleaning fluid which may be pure water, the movable member 62 is located at a descent position indicated by dashed double-dotted line in the drawing to close the annular inlet 63, thereby preventing the cleaning fluid from flowing into the etching solution recovery means 6.

The illustrated etching device 1 is equipped with etching solution supply means 7 for supplying the etching solution to the SOI substrate 10 held on the spinner table 2. The etching solution supply means 7 in the illustrated embodiment has an etching solution accommodation tank 71. Within the etching solution accommodation tank 71, an etching solution 72 is accommodated which is to be applied to the upper surface of the SOI substrate 10 (comprising silicon) placed on the spinner table 2. The etching solution 72 is an aqueous solution containing nitric acid and hydrofluoric acid. The etching solution 72 within the etching solution accommodation tank 71 is delivered by a pump 73, and supplied through a solution feed pipe 74 onto the upper surface of the SOI substrate 10 on the spinner table 2. The illustrated etching solution supply means 7 is furnished with an etching solution supply nozzle 75 for supplying the etching solution to a rotation center portion of the SOI substrate 10 held on the spinner table 2. The etching solution supply nozzle 75 is connected to the solution feed pipe 74. The etching solution supply nozzle 75 is adapted to be selectively located at an operating position (the position shown in FIG. 3) above the SOI substrate 10 held on the spinner table 2, and a nonoperating position separated from the site above the SOI substrate 10.

The illustrated etching device 1 is also furnished with etching solution discharge means 8 for discharging the etching solution recovered into the recovery tank of the etching solution recovery means 6. The etching solution discharge means 8 is comprised of a drain pipe 81 connected to a discharge port (not shown) provided in the annular bottom wall 61b forming the recovery tank of the etching solution recovery means 6, and a drain tank 82 for accommodating the etching solution discharged through the drain pipe 81.

The illustrated etching device 1 is constituted as described above, and etching of the SOI substrate 10 will be described below.

The pump 73 of the etching solution supply means 7 is actuated to feed the etching solution 72 within the etching solution accommodation tank 71 through the solution feed pipe 74 and direct a jet of the etching solution 72 through the etching solution supply nozzle 75 toward the upper surface of the backing layer 11 of the SOI substrate 10 held on the spinner table 2. By so doing, etching is carried out. When the etching solution 72 containing nitric acid and hydrofluoric acid is jetted at the upper surface of the backing layer 11 of the SOI substrate 10 comprising silicon, etching of the backing layer 11 of the SOI substrate 10 comprising silicon can be represented by:

$$Si + 2HNO_3 + 6HF \rightarrow H_2SiF_6 + 3H_2O + NO_2 + NO$$

In a situation where a sufficient amount of nitric acid is present, the etching rate is determined by the concentration of hydrofluoric acid and the temperature of the etching solution 82. To set the required etching rate, therefore, it is important to set the temperature of the etching solution 82 at a predetermined value and to set the nitric acid content in the etching solution 82 at an excess value and also set the content of hydrofluoric acid at a predetermined value. For example, when silicon (Si) is etched with the etching solution containing hydrofluoric acid (50%) and nitric acid (70%) mixed at a ratio of 1:4.5, etching takes place at a rate of 30 $\mu$m/min. When silicon oxide ($SiO_2$) is etched with the etching solution having the above-mentioned mixing ratio, the etching rate is 0.5 $\mu$m/min. Thus, the etching rate for silicon oxide ($SiO_2$) is very low, 1/60 of the etching rate for silicon (Si).

In etching the backing layer 11 by supplying the etching solution 72 to the upper surface of the backing layer 11 of the SOI substrate 10 held on the spinner table 2, the spinner table 2 is rotated at a speed which may be of the order of 600 rpm, whereby the etching solution 72 jetted from the etching solution supply nozzle 75 is flowed sufficiently uniformly throughout the upper surface of the backing layer 11 of the SOI substrate 10. The air flow means 5 annexed to the spinner table 2 flows air from the peripheral edge of the spinner table 2 along the lower surface of the SOI substrate 10, thereby preventing the etching solution 72 from contacting the lower surface, i.e. face, of the SOI substrate 10. The movable member 62 of the etching solution recovery means 6 is located at the ascent position indicated by the solid lines in the drawing, so that the etching solution 72 flowed over the upper surface of the SOI substrate 10 is recovered into the etching solution recovery means 6. The etching solution 72 recovered into the etching solution recovery means 6 is discharged into the drain tank 82 through the drain pipe 81 of the etching solution discharge means 8.

In the above-described etching step, the backing layer 11 of the SOI substrate 10 held on the spinner table 2 is formed of silicon (Si), and is thus etched at a rate of 30 $\mu$m/min as stated earlier. When the thickness of the backing layer 11 is 400 $\mu$m as described earlier, therefore, it takes about 13.4 minutes to etch the backing layer 11. Hence, the backing layer 11 of the SOI substrate 10 can be removed by about 13.4 minutes of etching, with the result that the insulating layer 12 is exposed. The etching rate for silicon oxide ($SiO_2$), the insulating layer 12, is 0.5 $\mu$m/min as described earlier. Thus, even if part of the insulating layer 12 is rapidly exposed owing to variations in the etching of the backing layer 11, the insulating layer 12 functions as a stopper, and the backing layer 11 can be removed completely. Since the backing layer 11 can be completely removed, the thickness of the SOI substrate 10 comes to be of the order of 2.1 to 3.5 $\mu$m which is the sum of the thickness of the insulating layer 12 (0.1 to 0.5 $\mu$m) and the thickness of the thin semiconductor film layer 13 and the circuit 14 (2 to 3 $\mu$m). By so removing the backing layer 11 by etching, the SOI substrate can be processed to be thin, without stress remaining as in grinding.

As stated earlier, after completion of the etching step for the backing layer 11 constituting the SOI substrate 10 held on the spinner table 2, the SOI substrate 10 on the spinner table 2 can be rinsed and dried, where necessary. A rinsing step can be performed by retreating the supply nozzle 75, which is designed to supply the etching solution 72, from the operating position above the SOI substrate 10 to the nonoperating position, locating a jet nozzle (not shown), which serves to jet a cleaning fluid, optionally, pure water, at a position above the SOI substrate 10, and jetting the cleaning fluid at the upper surface of the SOI substrate 10. On this occasion, the movable member 62 of the etching solution recovery means 6 is lowered to the descent position indicated by the dashed double-dotted lines in the drawing to close the annular inlet 63 of the etching solution recovery means 6, thereby preventing the cleaning fluid from entering the etching solution recovery means 6. Drying of the SOI substrate 10 can be performed by so-called spin drying which is a procedure for rotating the spinner table 2 at a high speed, for example, as high as 2000 to 3000 rpm.

Next, the second embodiment of a method for processing an SOI substrate according to the present invention will be described.

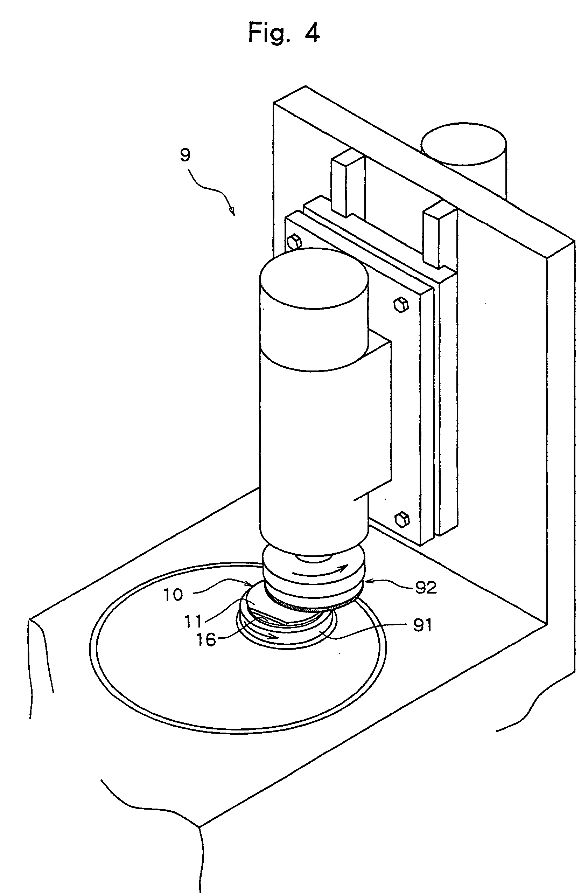

In the second embodiment, a backing layer 11 constituting an SOI substrate 10 is ground to leave a predetermined thickness (for example, 100 to 10 µm) (grinding step). That is, the SOI substrate 10, which has a protective member 16 stuck to the face of a thin semiconductor film layer 13 where circuits 14 are formed (see FIGS. 1 and 2) as stated earlier, is held on a chuck table 91 of a grinding device 9 shown in FIG. 4, with the backing layer 11 directed upwards. Once the SOI substrate 10 has been held on the chuck table 91, with the backing layer 11 facing upwards, a grinding wheel 92 is rotated, for example, at 6000 rpm while the chuck table 91 is being rotated, for example, at 300 rpm. In this state, the grinding wheel 92 is brought into contact with the backing layer 11 of the SOI substrate 10 to grind the backing layer 11. Grinding continues until the thickness of the backing layer 11 reaches a predetermined value, for example, 70 µm.

After the backing layer 11 of the SOI substrate 10 is ground in the above grinding step until its thickness reaches a predetermined value, for example, 70 µm, the above-described etching step is performed to etch away the backing layer 11, thereby exposing the insulating layer 12. In the second embodiment, as noted here, the backing layer 11 of the SOI substrate 10 is removed by the grinding step and the etching step. Thus, productivity can be increased compared with the aforementioned first embodiment in which the backing layer 11 is etched away only by the etching step. In the second embodiment, moreover, after the backing layer 11 of the SOI substrate 10 is ground by the grinding step until its thickness reaches a predetermined value, for example, 70 µm, the backing layer 11 left with this uniform thickness is etched away in the etching step by etching lasting 140 seconds, which is a period of time enough for the backing layer 11 of 70 µm in thickness to be completely removed by etching. Thus, the finished thickness of the SOI substrate 10 can be rendered uniform.

The etching characteristics of the above-described etching device are now described. The etching solution supplied to the rotation center portion of the backing layer 11 of the SOI substrate 10 held on the spinner table 2 increases in temperature owing to accumulation of heat of reaction, frictional heat due to rotation, and activating action. For example, its temperature is as low as 20°C at the center of the SOI substrate 10 with a diameter of 300 mm or so, but rises to as high as 70°C at an outer peripheral portion of the SOI substrate 10. This temperature rise of the etching solution increases the rate of reaction, and the amount of removal by etching becomes larger toward the outer periphery of the material to be etched. As noted here, the amount of removal by etching differs among the central portion, the intermediate portion, and the outer peripheral portion. With the SOI substrate 10 having a large diameter, therefore, if all of the backing layer 11 (about 400 µm in thickness) is to be removed by etching, great differences arise among the central portion, the intermediate portion and the outer peripheral portion in terms of the time taken until the insulating layer 12 is reached. As a result, if the diameter of the SOI substrate 10 is large, it may be impossible to etch away all of the backing layer 11 within the period of time (2 to 5 seconds) during which the insulating layer 12 can function as a stopper against the etching action. In this case, the amount of etching cannot be managed based on the etching rate. In the second embodiment, however, after the backing layer 11 of the SOI substrate 10 is ground and thinned by the grinding step, the resulting thin backing layer 11 is etched away in the etching step. This procedure does not produce great differences among the central portion, the intermediate portion and the outer peripheral portion in terms of the time taken until the insulating layer 12 is reached. Thus, all of the backing layer 11 can be etched away within the period of time (2 to 5 seconds) during which the insulating layer 12 can function as a stopper against the etching action. This makes it possible to manage the amount of etching based on the etching rate.

The present invention has been described above based on the illustrated embodiments, but the present invention is not limited to these embodiments alone. The above embodiments present examples in which wet etching with the etching solution is applied as chemical etching in the etching step. In the present invention, however, dry etching, such as plasma etching using, for example, XeF2 or SF6 gas, may be adopted as chemical etching.

Industrial Applicability

The method for processing the SOI substrate according to the present invention, as described above, utilizes the extreme difference in the etching rate between the semiconductor member, such as silicon, and the insulating member formed by oxidation of the semiconductor member. Utilizing this difference, the method removes the backing layer of the SOI substrate by etching to expose the insulating layer. Thus, the SOI substrate can be processed to be thin, without stress remaining as in grinding. Semiconductor chips formed by dicing the thus processed SOI substrate are so thin that their thermal characteristics and electrical characteristics are satisfactory. In constructing a semiconductor device of a multilayer structure by interconnecting the semiconductor chips in an up-and-down direction, care should be taken not to diffuse a metal such as copper, which forms electrodes ranging from the circuits to the back side, into the semiconductors. To prevent this diffusion, an insulating film, such as silicon oxide ($SiO_2$), needs to be formed around the electrodes. The SOI substrate processed by the present invention, on the other hand, has the insulating layer exposed as described above, and thus does not require that an insulating film be formed anew.

In the method for processing the SOI substrate according to the present invention, moreover, after the backing layer of the SOI substrate is ground and thinned by the grinding step, the resulting thin backing layer is etched away in the etching step. Thus, productivity can be increased compared with the technology of etching away the backing layer by the etching step alone. Furthermore, the above remaining thin backing layer is removed by etching, so that great differences are not produced among the central portion, the intermediate portion and the outer peripheral portion in terms of the time taken until the insulating layer is reached. Thus, all of the backing layer can be etched away within the period of time during which the insulating layer can function as a stopper against the etching action. This makes it possible to manage the amount of etching based on the etching rate.

**Claims**

1. A method for processing an SOI substrate composed of a backing layer comprising a semiconductor substrate, an insulating layer laminated on an upper surface of said backing layer, a thin semiconductor film layer laminated on an upper surface of said insulating layer, and circuits formed on a face of said thin semiconductor film layer, **characterized by**
   including an etching step of removing said backing layer by chemical etching to expose said insulating layer.

2. A method for processing an SOI substrate composed of a backing layer comprising a semiconductor substrate, an insulating layer laminated on an upper surface of said backing layer, a thin semiconductor film layer laminated on an upper surface of said insulating layer, and circuits formed on a face of said thin semiconductor film layer, **characterized by** including:

   a grinding step of grinding said backing layer so as to remain with a predetermined thickness; and
   an etching step of removing said backing layer, which has been formed to the predetermined thickness by said grinding step, by chemical etching to expose said insulating layer.

3. The method for processing an SOI substrate according to claim 2, wherein the predetermined thickness of said backing layer remaining in said grinding step is set at 100 to 10 $\mu$m.

4. The method for processing an SOI substrate according to any one of claims 1 to 3, wherein said backing layer is formed from silicon (Si), and said insulating layer is formed from silicon oxide ($SiO_2$).

5. The method for processing an SOI substrate according to any one of claims 1 to 4, wherein the chemical etching in said etching step is performed using an etching solution containing fluorine and nitric acid.

## Fig. 1

10

14

## Fig. 2

14    12    14    13

11

10

Fig. 3

EP 1 427 018 A1

# Fig. 4

## INTERNATIONAL SEARCH REPORT

| | International application No. |
|---|---|
| | PCT/JP03/08895 |

**A. CLASSIFICATION OF SUBJECT MATTER**
Int.Cl⁷ H01L27/12

According to International Patent Classification (IPC) or to both national classification and IPC

**B. FIELDS SEARCHED**

Minimum documentation searched (classification system followed by classification symbols)
Int.Cl⁷ H01L27/12, H01L21/304, H01L21/306-21/3063, H01L21/308,
          H01L21/78-21/80

Documentation searched other than minimum documentation to the extent that such documents are included in the fields searched

| Jitsuyo Shinan Koho | 1922-1996 | Toroku Jitsuyo Shinan Koho | 1994-2003 |
|---|---|---|---|
| Kokai Jitsuyo Shinan Koho | 1971-2003 | Jitsuyo Shinan Toroku Koho | 1996-2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 99/48143 A2  (KONINKLIJKE PHILIPS ELECTRONICS<br>N.V.),<br>23 September, 1999 (23.09.99),<br>Full text; Figs. 1 to 13<br>& JP 2001-527700 A<br>Full text; Figs. 1 to 13<br>& EP 988650 A2       & US 6177295 B1 | 1-4<br>5 |
| Y | JP 5-63211 A  (Mitsubishi Electric Corp.),<br>12 March, 1993 (12.03.93),<br>Full text; Figs. 1 to 3<br>(Family: none) | 5 |

| ☒ | Further documents are listed in the continuation of Box C. | ☐ | See patent family annex. |
|---|---|---|---|

\* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 September, 2003 (29.09.03) | 14 October, 2003 (14.10.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

**EP 1 427 018 A1**

<table>
<tr><td colspan="3">INTERNATIONAL SEARCH REPORT</td><td>International application No.<br>PCT/JP03/08895</td></tr>
</table>

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | EP 545694 A2 (CANON KABUSHIKI KAISHA),<br>09 June, 1993 (09.06.93),<br>Full text; Figs. 1 to 29<br>& JP 5-257171 A<br>Full text; Figs. 1 to 33<br>& DE 69225385 D          & US 5317433 A<br>& US 5633182 A | 5 |

Form PCT/ISA/210 (continuation of second sheet) (July 1998)

11